# EUROPEAN PATENT APPLICATION

(11) **EP 2 085 325 A1**
(43) Date of publication of application: **05.08.2009**
(21) Application number: 06833288.1
(22) Date of filing: 24.11.2006
(51) Int. Cl.: B65D 85/86

(54) **SHEET STORING CARRIER SYSTEM AND RETICLE CASE MAKING USE OF THE SAME**

(71) Applicant: Miraial CO., LTD., Tokyo 171-0021 (JP)
(72) Inventor: IWAKI, Tadao, Tokyo 171-0021 (JP); UMEDA, Toshiya, Musashino-shi Tokyo 180-0022 (JP)
(74) Representative: Grünecker, Kinkeldey, Stockmair & Schwanhäusser Anwaltssozietät
(86) International application number: PCT/JP2006/323484
(87) International publication number: WO 2008/062537

(57) **Abstract**

A thin plate storage transport system including a pressure container for containing a thin plate provided with a container main body for containing one or a plurality of thin plates, a lid body attached by covering the container main body, and a seal for airtightly isolating a containing space formed inside from an outside environment when the container main body is closed and covered by the lid body; and a pressure supply device for setting a pressure inside the containing space at a set pressure higher than an outside pressure by supplying a pressure into the containing space of the pressure container for containing a thin plate. As a result, the inside of the containing space can be kept at high cleanliness for a long time.

## Description

### TECHNICAL FIELD

The present invention relates to a thin plate storage transport system and a reticle case using the same improved so that an inside can be maintained in a clean state for a long time.

### BACKGROUND ART

A container for storing a reticle is generally known. There is a reticle transport container as in Patent Document 1, for example. This reticle transport container is a transport container provided with a pod for containing a reticle, a door for airtightly sealing by closing the pod and a seal.

Using this reticle transport container, the reticle can be transported with the inside maintained in a clean state.
Patent Document 1: Japanese Patent Laid-Open No. 2006-146079

### DISCLOSURE OF THE INVENTION

### PROBLEM TO BE SOLVED BY THE INVENTION

With the above reticle transport container, sufficient cleanliness can be maintained without any problem for a conventional reticle, and the reticle can be transported safely.

However, the required cleanliness inside the reticle transport container has become increasingly higher, and it is necessary to highly isolate intrusion of particles from outside and to highly maintain the cleanliness of the inside. This also applies to a container for containing a thin plate such as a semiconductor wafer.

The present invention is made in view of the above demand and has an object to provide a thin plate storage transport system and a reticle case using the same that can maintain the inside at high cleanliness for a long time.

### MEANS TO SOLVE THE PROBLEMS

The present invention is made in view of the above circumstances, and a thin plate storage transport system of the present invention comprises a pressure container for containing a thin plate provided with a container main body for containing one or a plurality of thin plates, a lid body that can be attached by covering the container main body, and a seal for airtightly isolating a containing space formed inside from an outside environment when the container main body is closed and covered by the lid body, and a pressure supply device for setting a pressure in the containing space at a set pressure higher than an outside pressure by supplying a pressure into the containing space of the pressure container for containing a thin plate.

With the above configuration, the containing space of the pressure container for containing a thin plate for containing a reticle and the like can be maintained clean, and by setting the pressure inside the containing space at the set pressure higher than the outside pressure by the pressure supply device, the inside of the containing space can be kept at a high cleanliness for a long time.

Also, the reticle case of the present invention comprises an inner container including a receiving body for containing a reticle, a lid body attached by covering the receiving body and a seal for airtightly isolating a containing space formed inside from an outside environment when the receiving body is closed and covered by the lid body; an outer container in which the inner container is contained; and a pressure supply device for setting a pressure in the containing space at a set pressure higher than a pressure in the outer container by supplying a pressure into the containing space of the inner container is provided.

With the above configuration, the containing space of the inner container for containing the reticle is kept clean, and by setting the pressure in the containing space at a set pressure higher than the outside pressure by the pressure supply device, the inside of the containing space can be kept at a high cleanliness for a long time.

### EFFECT OF THE INVENTION

As described above in detail, according to the thin plate container of the present invention, the following effects are exerted.

By maintaining a constant pressure of more uplift than the outside environment for a long time, intrusion of a particle and the like from outside can be highly isolated, contamination on the reticle and the like can be prevented, and safety in transport can be improved.

Also, by setting the pressure inside the container higher, a gas component generated from a container material can be kept at a low level, and substance contamination of a contained article can be reduced.

Moreover, by arranging a chemical filter in the container, a contaminant generated from the container or brought in by a contained article can be adsorbed and kept at a low level, and substance contamination of the contained article can be eliminated. Moreover, by constituting the reticle case in a double structure, a cleaner containing environment can be realized, and even if the outer container is broken, the inside of the inner container can be kept in a clean state, and reliability and safety during transport of the contained article can be improved.

### BRIEF DESCRIPTION OF THE DRAWINGS

Fig. 1 is a plane sectional view illustrating a thin plate storage transport system according to an embodiment of the present invention.
Fig. 2 is a side sectional view illustrating the thin plate storage transport system according to the embodiment of the present invention.
Fig. 3 is a plan view illustrating the thin plate storage transport system according to the embodiment of the present invention.
Fig. 4 is a side view illustrating the thin plate storage transport system according to the embodiment of the present invention.
Fig. 5 is an enlarged sectional view of an essential part illustrating a portion of a pressure supplier and a pressure governor.
Fig. 6 is an enlarged sectional view of an essential part illustrating a portion of the pressure supplier and the pressure governor.
Fig. 7 is an enlarged sectional view of an essential part illustrating a portion of the pressure supplier and the pressure governor.
Fig. 8 is an enlarged sectional view of an essential part illustrating a portion of the pressure supplier and the pressure governor.
Fig. 9 is an enlarged sectional view of an essential part illustrating a portion of the pressure supplier and the pressure governor.
Fig. 10 is an enlarged sectional view of an essential part illustrating a portion of the pressure supplier and the pressure governor.
Fig. 11 is an enlarged sectional view of an essential part illustrating a seal between a base and a cover.
Fig. 12 is an enlarged sectional view of an essential part illustrating the seal between the base and the cover.
Fig. 13 is an enlarged sectional view of an essential part illustrating a variation of the seal.
Fig. 14 is an enlarged sectional view of an essential part illustrating a variation of the seal.
Fig. 15 is an enlarged sectional view of an essential part illustrating a variation of the seal.
Fig. 16 is an enlarged sectional view of an essential part illustrating a variation of the seal.
Fig. 17 is a schematic diagram illustrating an operation at an opening and closing pressure regulating valve.
Fig. 18 is a schematic diagram illustrating an operation at the opening and closing pressure regulating valve.
Fig. 19 is a perspective view illustrating a reticle case.
Fig. 20 is a perspective view illustrating the reticle case in a state where an inner container is taken out of an outer container.
Fig. 21 is an enlarged sectional view of an essential part illustrating a respiratory valve.
Fig. 22 is a graph illustrating an example of a change in VOC concentration in a state where a chemical absorber is not used.
Fig. 23 is a graph illustrating a difference between a case in which the chemical absorber is used and a case in which not used.

### EXPLANATIONS OF REFERENCE NUMERALS

- 1: thin plate storage transport system
- 2: reticle
- 3: pressure container for containing a thin plate
- 4: pressure supply device
- 6: base
- 7: cover
- 8: stopper
- 9: pressure supplier
- 10: pressure governor
- 11: seal
- 13: loading base portion
- 14: seal receiver
- 15: supporting body
- 17: containing space
- 20: ventilation hole
- 21: check valve
- 22: filter
- 23: check valve containing chamber
- 24: filter containing chamber
- 26: valve seat
- 27: interface fitting portion
- 31: annular base portion
- 32: lip portion
- 33: annular base portion
- 34: upper lip portion
- 35: lower lip portion
- 36: protruding portion
- 37: annular base portion
- 38: upper lip portion
- 39: protruding portion
- 41: pressure supply portion
- 42: opening and closing pressure regulating valve
- 43: pressurized chamber
- 44: gas introduction interface
- 45: connection pipe
- 46: rotary valve
- 49: valve opening pin
- 51: reticle case
- 52: inner container
- 53: outer container
- 55: outer receiving body
- 56: outer lid body
- 57: chemical absorber
- 59: respiratory valve
- 61: valve containing recess portion
- 62: fitted pipe
- 65: fitting pipe portion
- 66: filter containing portion
- 67: open pipe portion
- 68: membrane filter

### BEST MODE FOR CARRYING OUT THE INVENTION

An embodiment of the present invention will be described below referring to the attached drawings. Here, first, a thin plate storage transport system will be described and then, a reticle case using the thin plate storage transport system will be described.

### [First embodiment]

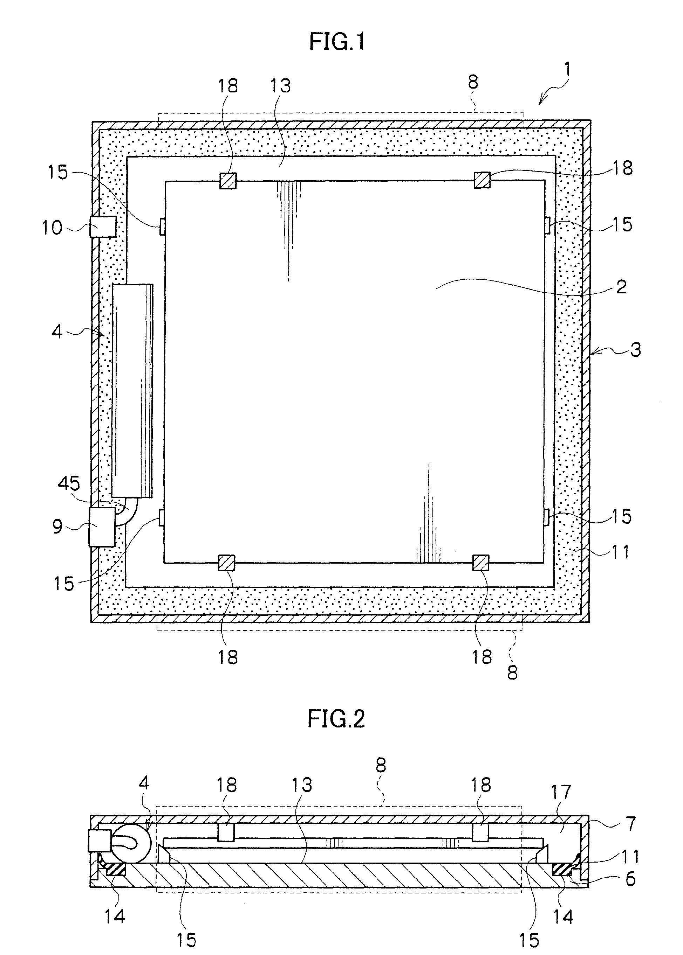

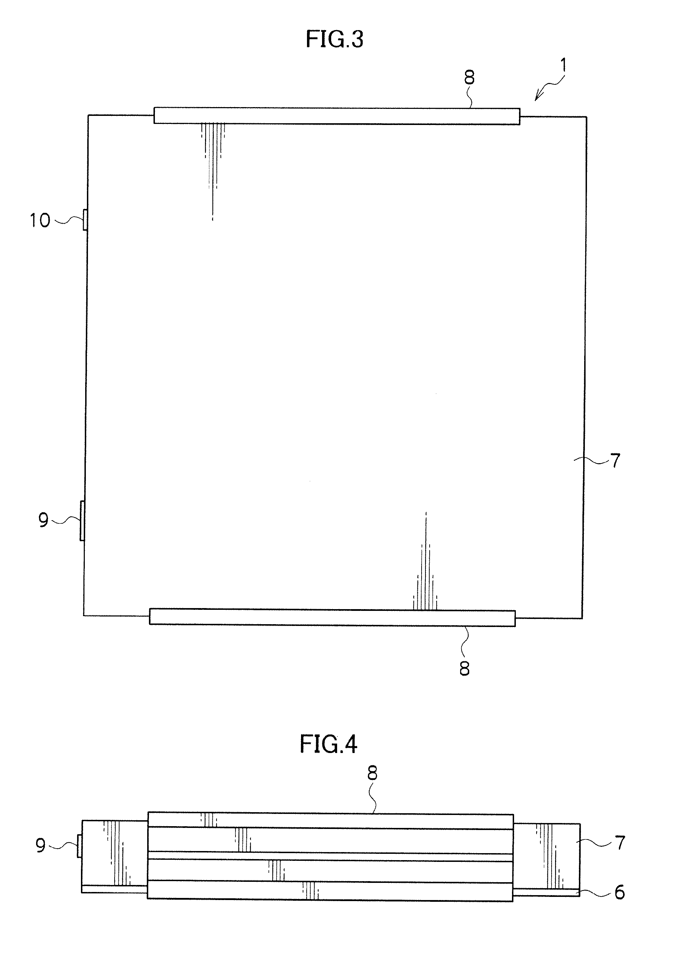

A thin plate storage transport system 1 according to this embodiment comprises, as shown in Figs. 1 to 4, a pressure container 3 for containing a thin plate for containing and transporting a reticle 2 inside in a state where an inside is kept clean and a pressure supply device 4 for supplying a pressure into the pressure container 3 for containing a thin plate so that a pressure inside the pressure container 3 for containing a thin plate is a set pressure higher than the outside pressure.

The pressure container 3 for containing a thin plate is a container for containing and transporting one or a plurality of thin plates such as the reticle 2 and semiconductor wafer (not shown) inside. In this embodiment, a container for containing a single piece of the reticle 2 as the thin plate will be explained as an example. The pressure container 3 for containing a thin plate is constituted by a base 6, a cover 7, a stopper 8, a pressure supplier 9, a pressure governor 10, and a seal 11. On a pattern forming face of the reticle 2 at this time, pellicle for preventing contamination on the surface may be attached.

The base 6 is a receiving body (container main body) for containing a single or a plurality of thin plates. Here, a single piece of the reticle 2 is contained in the base 6. The base 6 is constituted by a substantially flat-shaped plate material. On an upper face of the base 6, a loading base portion 13 on which the reticle 2 is loaded and a seal receiver 14 for supporting the seal 11 are provided for constitution.

The loading base portion 13 is formed in a square pedestal shape slightly larger than a dimension of the reticle 2. On the loading base portion 13, a supporting body 15 is provided. The supporting body 15 is a member for supporting the reticle 2. The supporting body 15 is provided in plural on the loading base portion 13 and supports a peripheral edge portion of the reticle 2 from below at a plurality of spots. Here, four supporting body 15 are provided to support a peripheral edge portion of the reticle 2 with four spots. The supporting body 15 is provided with an inclined face at a distal end portion thereof, and the inclined face is brought into contact with a corner portion of the periphery of the reticle 2 so that the reticle 2 is supported with a minimum area. The supporting body 15 is constituted by a plate-spring shaped supporting portion formed by an elastic polymer material such as polyethylene elastomer and polyester elastomer and a holding portion for supporting and constraining the supporting portion.

The seal receiver 14 is an annular groove in which the seal 11 is fitted. The seal receiver 14 is formed annularly around the loading base portion 13 of the base 6. The seal receiver 14 is formed in the groove shape with a section in a square shape and in which an annular base portion of the seal 11, which will be described later, is fitted.

The cover 7 is a lid body attached by covering the base 6. The cover 7 is formed in a reversed shallow disc shape. By attaching the cover 7 on the base 6, a containing space 17 is formed between the cover 7 and the base 6. On an inner side face of a top plate of the cover 7, supporting bodies 18 similar to the supporting body 15 of the loading base portion 13 are provided. Four supporting bodies 18 are provided at positions opposed to each of the supporting bodies 15 of the loading base portion 13, and the upper-side supporting body 18 and the lower-side supporting body 15 collaborate with each other to sandwich the reticle 2 from above and below.

The stopper 8 is a member for constraining the base 6 and the cover 7. In a state where the base 6 is covered by the cover 7, both end portions of the stopper 8 are hooked by respective edge portions of the base 6 and the cover 7 and constrained by each other. The stopper 8 may be constituted as a single member or attached to the base 6 or the base 7 rotatably.

As a material of the members constituting the pressure container 3 for containing a thin plate such as the base 6, cover 7, and stopper 8, polycarbonate, PBT, PEEK, PBN, thermoplastic resin, copper, aluminum, stainless steel and the like can be used. Particularly, in the case of aluminum, the surface may be anodized to have an oxidized file for use. Alternatively, the members may be constituted by a complex material of metal and plastic. For example, metal is used for the lid body, while a synthetic resin is used for the container main body.

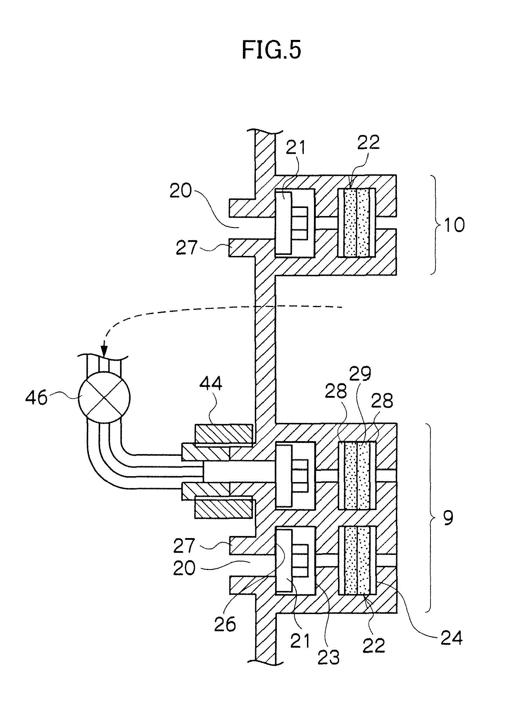

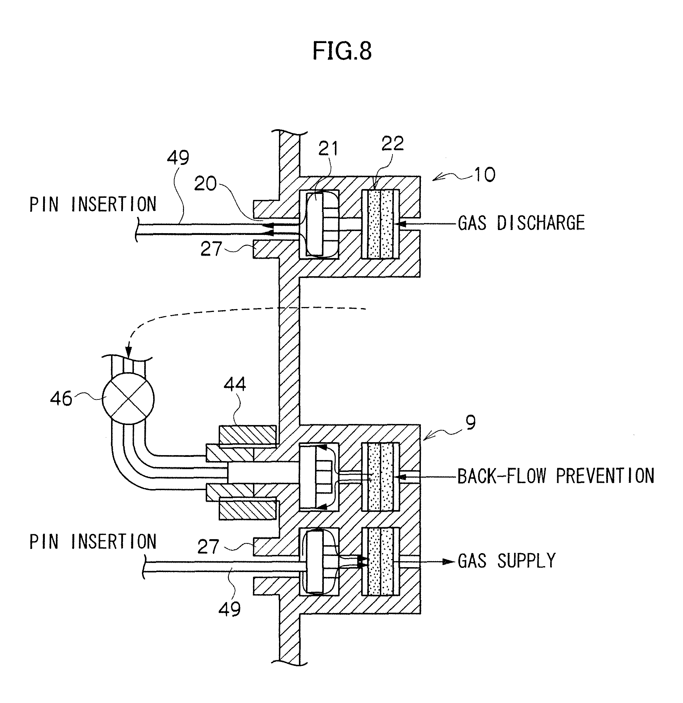

The pressure supplier 9 is a device connected to the pressure supply device 4 for supplying gas at a set pressure to the containing space 17. The pressure supplier 9 is constituted by, as shown in Figs. 5 to 10, a ventilation hole 20, a check valve 21, and a filter 22.

The ventilation hole 20 is a hole provided in the cover 7 for having inside and outside of the containing space 17 communicate with each other. At this ventilation hole 20, a check valve containing chamber 23 and a filter containing chamber 24 are provided. The check valve containing chamber 23 is formed by enlarging the ventilation hole 20 in the same shape as the plane shape of the check valve 21. In this embodiment, the check valve containing chamber 23 is formed by enlarging the ventilation hole 20 in the same shape as the plane shape of the check valve 21, but it is needless to say that any plane shape may be employed as long as the check valve 21 can freely movable in the check valve chamber 23 in the center axis direction, the ventilation hole 20 can be closed in an airtight manner and a flow passage from the ventilation hole 20 can be ensured.

By this check valve containing chamber 23, the check valve 21 contained inside is supported movably in the center axis direction of the ventilation hole 20. The check valve containing chamber 23 has its outside face (left side in Fig. 5) made as a valve seat 26. By bringing the check valve 21 into contact with the valve seat 26, the ventilation hole 20 is sealed. On an outer end portion of the ventilation hole 20, an interface fitting portion 27 is formed. The interface fitting portion 27 is a pipe portion where a gas introduction interface and a gas leading-out interface of the pressure supply device 4, which will be described later, are fitted. As the interface fitting portion 27, the gas introduction interface, and the gas leading-out interface, a known connection fitting can be used.

The check valve 21 has its plane shape formed in the shape similar to the inside shape of the check valve containing chamber 23 and with a dimension slightly smaller than that. As a result, the check valve 21 can freely move in the check valve containing chamber 23 in a state contained in the check valve containing chamber 23. As a result, the check valve 21 allows a flow of gas by moving to the containing space 17 side in the check valve containing chamber 23 against the flow of gas into the containing space 17 from outside. Also, against the opposite flow of gas from inside the containing space 17 to the outside, the check valve 21 is moved to the outer side in the check valve containing chamber 23 and is brought into contact with the valve seat 26 to block this gas flow.

The filter 22 is attached to the filter containing chamber 24. The filter 22 is constituted by a membrane filter 28 located on both sides, and a chemical filter 29 filled between each of the membrane filters 28. The membrane filter 28 blocks intrusion of a particle and the like. The chemical filter 29 eliminates a volatile organic compound.

The pressure supplier 9 with the above configuration is provided in one or two pieces. Specifically, if the pressure supply device 4 is connected to the pressure container 3 for containing a thin plate all the time, two ventilation holes 20 and the like are provided, while the pressure supply device 4 is not attached to the pressure container 3 for containing a thin plate but connected only when a pressure is to be supplied into the pressure container 3 for containing a thin plate, one piece of the ventilation hole 20 is provided. In this embodiment, two ventilation holes 20 and the like are provided. Also, the ventilation hole 20 may be provided either one or both of the base 6 side or the cover 7 side. It is provided at positions and in the number according to a required function.

The pressure governor 10 is a device for flowing gas in the containing space 17 outside as necessary so as to lower the pressure. The pressure governor 10 has the same configuration as that of the pressure supplier 9. That is, the pressure governor 10 is constituted by the ventilation hole 20, the check valve 21, and the filter 22.

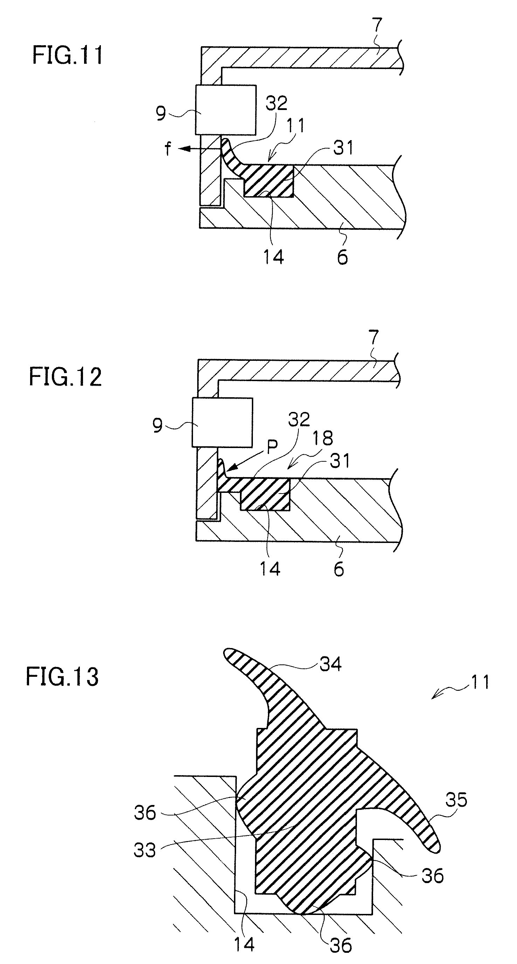

The seal 11 is a member for airtightly isolating the containing space 17 formed inside when the base 6 is closed and covered by the cover 7 from the outside environment. As the seal 11, various shapes can be used. The seal 11 is constituted by, as shown in Figs. 11 and 12, for example, an annular base portion 31 fitted with the annular seal receiver 14 and a lip portion 32 in close contact with an inner face of a side wall in the cover 7. The annular base portion 31 is formed with a section in a square shape so as to be in close contact with the seal receiver 14. The lip portion 32 is formed extending toward the inner face of the side wall in the cover 7 from the annular base portion 31, and its distal end side is brought into close contact with the inner face of the side wall in the cover 7 to seal the containing space 17. The lip portion 32 seals the inside of the containing space 17 by being strongly brought into close contact with the inner face of the side wall in the cover 7 by an elasticity f of its own and a pressure P in the containing space 17.

Alternatively, the seal 11 may be configured as shown in Figs. 13 to 15. In the case of the seal 11, this is constituted by an annular base portion 33 fitted in the annular seal receiver 14, an upper lip portion 34 in close contact with the inner face of the side wall in the cover 7, and a lower lip portion 35 in close contact with an upper-side face of the base 6. The annular base portion 33 is formed with a section in a square shape, and protruding portions 36 which improve close contact are formed on three faces in contact with the seal receiver 14. With these portions, when the annular base portion is fitted with the seal receiver 14, the three protruding portions 36 are brought into contact with the seal receiver 14, respectively, so as to be closely fitted. The upper lip portion 34 is formed extending to the inner face of the side wall in the cover 7 from the annular base portion 33, and its distal end side is brought into close contact with the inner face of the side wall in the cover 7 to seal the containing space 17. The lower lip portion 35 is formed extending to the upper-side face of the base 6 from the annular base portion 33, and its distal end side is pressed by the pressure P in the containing space 17 so as to be brought into close contact with the upper-side face of the base 6 and to seal the containing space 17.

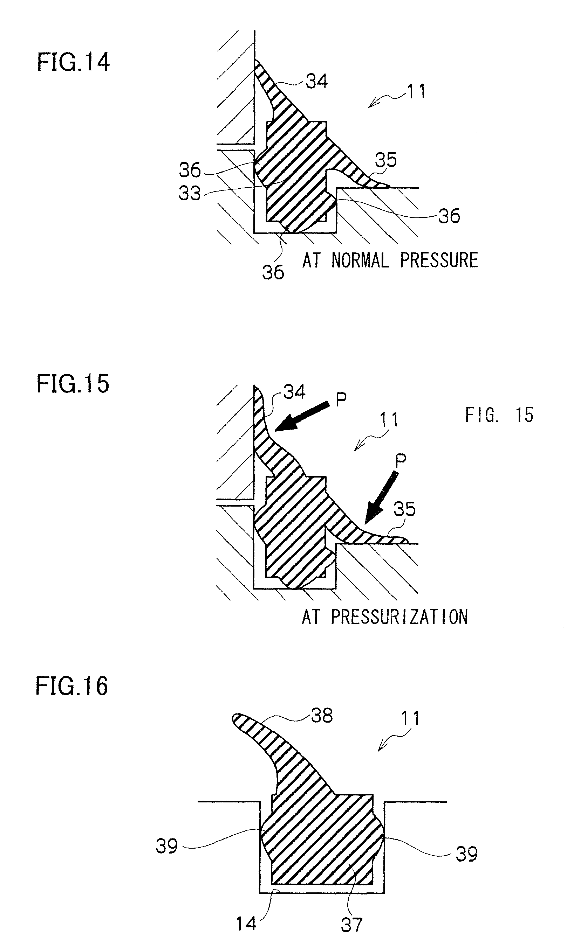

Alternatively, the seal 11 may be configured as shown in Fig. 16. In the case of this seal 11, it is constituted by an annular base portion 37 fitted with the annular seal receiver 14 and an upper lip portion 38 in close contact with the inner face of the side wall in the cover 7. The annular base portion is formed with a section in a square shape, and a protruding portion 39 which improves close contact is formed on two faces in contact with the wall face opposite the seal receiver 14. By these portions, when the annular base portion 37 is fitted with the seal receiver 14, the two protruding portions 39 are brought into contact with the seal receiver 14, respectively, and closely fitted. The upper lip portion 38 is formed extending to the inner face of the side wall in the cover 7 from the annular base portion 37, and its distal end side is brought into close contact with the inner face of the side wall in the cover 7 to seal the containing space 17.

The pressure supply device 4 in Fig. 1 is a device for supplying a pressure into the containing space 17 of the pressure container 3 for containing a thin plate with the above configuration so as to bring the pressure in the containing space 17 to the set pressure higher than the pressure outside. The inside of the pressure container 3 for containing a thin plate is kept at the set pressure by this pressure supply device 4, and inflow of gas from outside is prevented. The set pressure is 1.1 to 2 atmospheric pressure or preferably 1.1 to 1.5 atmospheric pressure. Specifically, the pressure is set slightly higher than the outside pressure. If the pressure in the containing space 17 is higher than the outside pressure if even slightly, outside air does not go into the containing space 17, and intrusion of a particle and the like can be prevented. If a transport path is only on land, the pressure is 1 atmospheric pressure substantially over the whole travel, and the pressure is set at approximately 1.1 atmospheric pressure. If an undersea tunnel is used, the pressure is set at approximately 1.1 to 1.5 atmospheric pressure depending on the depth, or specifically, the pressure is set to an atmospheric pressure slightly higher than a value at which the atmospheric pressure is the highest in the undersea tunnel. If an airplane is used, since the air pressure is lowered during the flight and the highest atmospheric pressure is 1 atmospheric pressure on land, the pressure is set at 1.1 atmospheric pressure. Essentially, the pressure is set at a pressure sufficiently higher than the outside pressure. Thus, setting at 2 atmospheric pressure or above may be considered, but in connection with the strength of the pressure container 3 for containing a thin plate, the pressure is set at a pressure slightly higher than the highest atmospheric pressure in the atmospheric pressure during the transport. If the strength of the pressure container 3 for containing a thin plate allows, the pressure may be set at a sufficiently high value. Also, by maintaining the internal pressure close to 1 pressure, maintenance of a constant pressure for a longer time is facilitated. By setting the internal pressure at approximately 1 to 1.2 atmospheric pressure, a pressure cylinder may be omitted if it is for a short time.

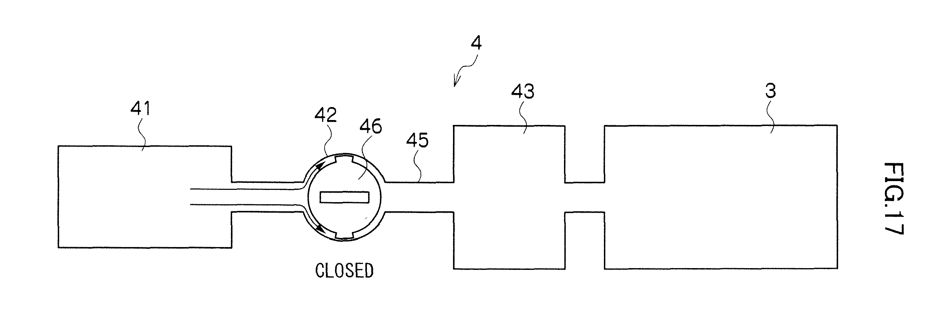

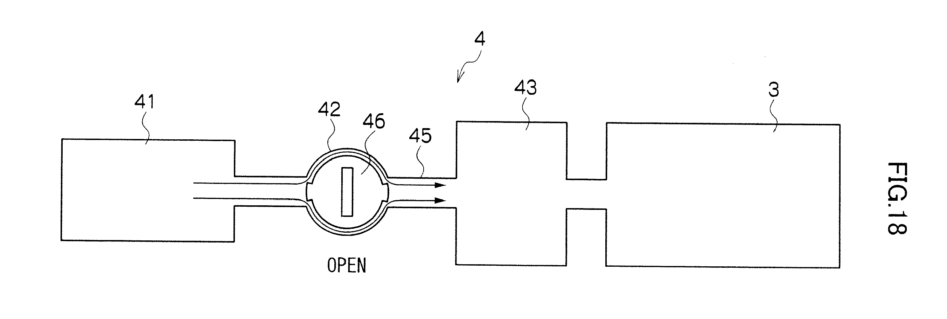

The pressure supply device 4 is, as shown in Figs. 17 and 18, constituted by a pressure supply portion 41, an opening and closing pressure regulating valve 42, a pressurized chamber 43, a gas introduction interface 44 (See Fig. 5), and a gas leading-out interface (not shown). The pressure supply device 4 is apparently formed in a lengthy cylinder as shown in Figs. 1, 2, and is constrained to the inside of the cover 7. The device might be constrained to the base 6.

The pressure supply portion 41 is a device for supplying a pressure, which is high to some degree (2 atmospheric pressure or more, and usually 5 to 15 atmospheric pressure). This pressure supply portion 41 is constituted by a pressure cylinder in this embodiment. As a result, the pressure supply device 4 can be incorporated in the pressure container 3 for containing a thin plate, the pressure supply device 4 can be transported with the pressure container 3 for containing a thin plate, and the inside of the containing space 17 can be kept at the set pressure all the time during the transport of the pressure container 3 for containing thin plate.

The opening and closing pressure regulating valve 42 is provided at a connection pipe 45 connecting the pressure supply portion 41 and the pressure container 3 for containing a thin plate and this is a valve for opening and closing the connection pipe 45 and for regulating the pressure at the same time. The opening and closing pressure regulating valve 42 is constituted by a rotary valve 46. If the rotary valve 46 is laid down (to the state in Fig. 17), a passage is blocked and brought into a closed state. Also, if the rotary valve is stood vertically (to the state in Fig. 18), it is brought into an open state, an orifice is created before and after the rotary valve, respectively, and pressure is reduced in two stages. As a result, the pressure of the gas with 5 to 15 atmospheric pressure is reduced to the set atmospheric pressure (approximately 1.1 to 2 atmospheric pressure).

The pressurized chamber 43 is an accumulator for buffering an impact caused by pressure fluctuation and the like. If the pressure fluctuation or disturbance in a flow velocity is caused due to switching and the like of the opening and closing pressure regulating valve 42, the pressure fluctuation or the disturbance in the flow velocity is absorbed in the pressurized chamber 43, and the pressure is supplied to the containing space 17 of the pressure container 3 for containing a thin plate in a stable state. This pressurized chamber 43 is provided if the pressure fluctuation or disturbance in the flow velocity is large. In Fig. 5, the pressurized chamber 43 is not provided.

The gas introduction interface 44 is a connection fitting to be fitted in the interface fitting portion 27 of the ventilation hole 20. The gas introduction interface 44 is provided at an end portion on the downstream side of the pressurized chamber 43. As shown in Fig. 5, the gas introduction interface 44 may be provided at the end portion on the downstream side of the opening and closing pressure regulating valve 42.

In this gas introduction interface 44, a known connection fitting can be used with the interface fitting portion 27.

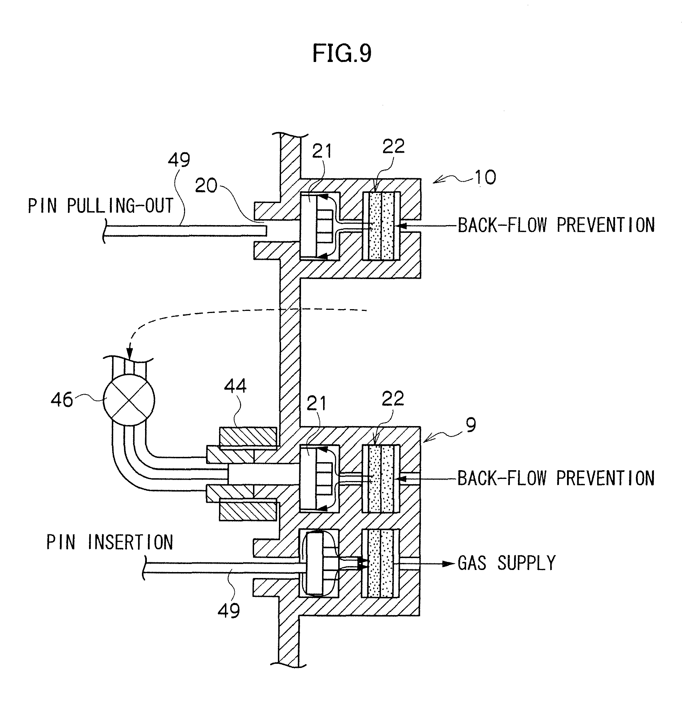

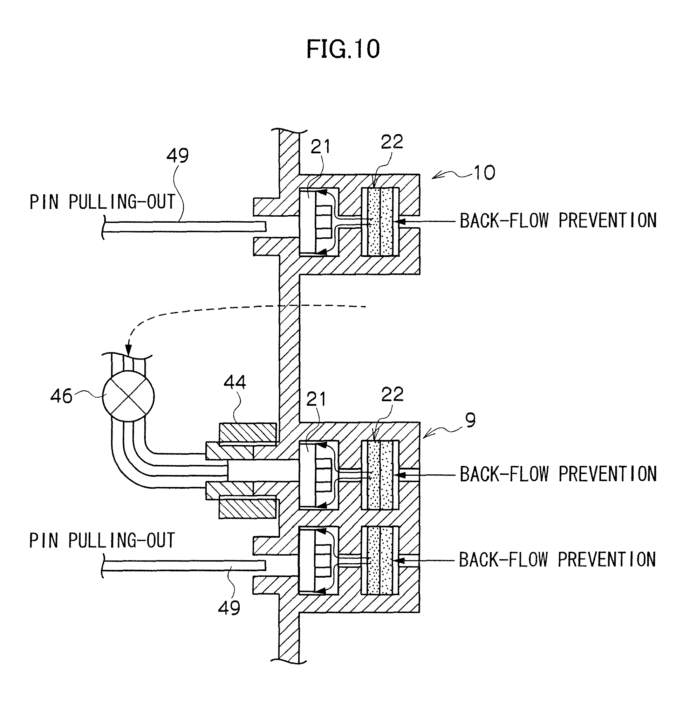

The gas leading-out interface is a connection fitting to be fitted with the interface fitting portion 27 of the ventilation hole 20 on the pressure governor 10 side. The gas introduction interface 44 has the same configuration as that of the gas introduction interface 44, and a known connection fitting can be used as with the interface fitting portion 27. Moreover, in the gas leading-out interface, a valve opening pin 49 (See Figs. 9, 10) is provided inside. The valve opening pin 49 pushes and opens the check valve 21 in the ventilation hole 20 to open the ventilation hole 20 when the gas introduction interface is fitted with the interface fitting portion 27, and when the gas leading-out interface is pulled out of the interface fitting portion 27, the check valve 21 in the ventilation hole 20 is returned to the original state and the ventilation hole 20 is closed. The valve opening pin 49 might be provided at the gas introduction interface 44.

### [How to use]

The thin plate storage transport system 1 with the above configuration is transported by attaching the pressure supply device 4 to the pressure container 3 for containing a thin plate or is transported without attaching the pressure supply device 4 to the pressure container 3 for containing a thin plate.

When the pressure supply device 4 attached to the pressure container 3 for containing a thin plate is transported, as shown in Fig. 1, in a state where the pressure supply device 4 is attached to the inside of the cover 7 in the pressure container 3 for containing a thin plate, the gas at the set pressure is supplied into the containing space 17 from the pressure supplier 9 to keep the inside of the containing space 17 at the set pressure all the time.

The pressure at 5 to 15 atmospheric pressure in the pressure supply portion 41 is reduced to the set pressure (1.1 atmospheric pressure, for example) by the opening and closing pressure regulating valve 42 and the set pressure reaches to the inside of the containing space to keep the inside of the containing space 17 at the setting pressure through the pressure supplier 9 connected to the pressurized chamber 43 and the gas introduction interface 44 with the interface fitting portion 27.

As a result, the reticle 2 in the pressure container 3 for containing a thin plate is kept in a clean state all the time and transported to a destination. Even if the atmospheric pressure is fluctuated during the transport, since the set pressure is set at a value considering a width of fluctuation in the atmospheric pressure, the reticle 2 in the pressure container 3 for containing a thin plate is kept in the clean state all the time.

At this time, the pressure supplier 9 and the pressure governor 10 operate as follows.

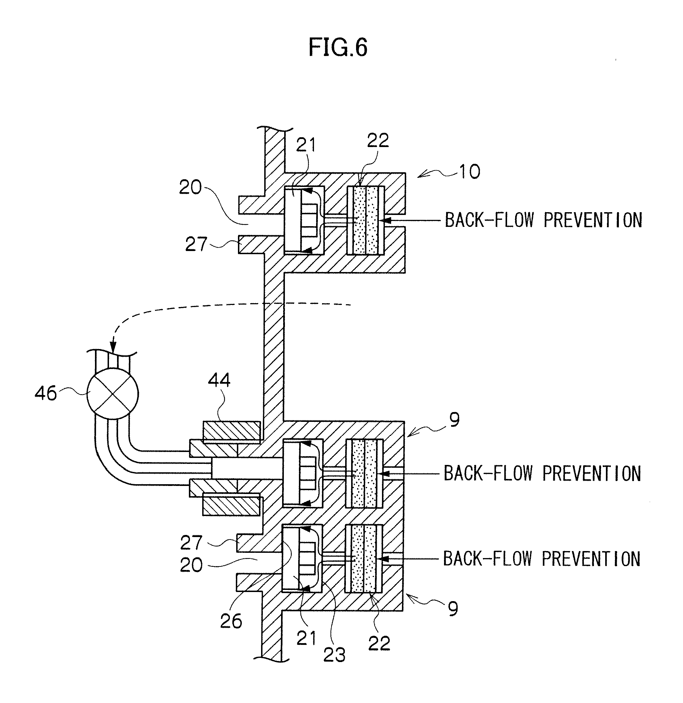

If the pressure inside the pressure container 3 for containing a thin plate is higher than the outside pressure, as shown in Fig. 6, the two check valves 21 in the pressure supplier 9 and the one check valve 21 in the pressure governor 10 are all pressed onto the valve seat 26 and closed to seal the inside of the containing space 17.

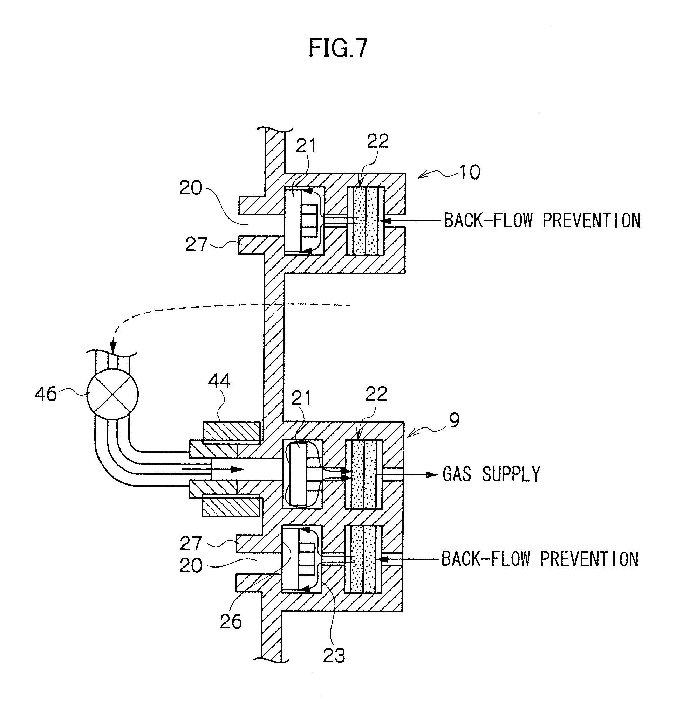

If the pressure inside the containing space 17 becomes lower than the pressure of the pressure supply device 4, as shown in Fig. 7, the check valve 21 of the pressure supplier 9 to which the pressure supply device 4 is connected is opened, and the set pressure of the pressure supply device 4 reaches to the containing space 17 so as to raise the internal pressure of the containing space 17 to the set pressure. At this time, the other check valve 21 of the pressure supplier 9 and the check valve 21 of the pressure governor 10 are not opened but seals the inside of the containing space 17.

As a result, the pressure inside the containing space 17 can be maintained higher than the outside pressure all the time, and the reticle 2 in the pressure container 3 for containing a thin plate can be kept in the clean state all the time and transported to the destination.

On the other hand, if the pressure supply device 4 is not attached to the pressure container 3 for containing a thin plate in transport, the inside of the containing space 17 is set to the set pressure in advance, and the pressure container 3 for containing a thin plate is transported to the destination in a state where the pressure is maintained.

Also, when the new reticle 2 is to be contained for transport, it is conducted as follows.

The reticle 2 is placed on the supporting body 15 of the base 6 and the cover 7 is closed, and the base 6 and the cover 7 are joined by the stopper 8.

On the pressure supplier 9 and the pressure governor 10, the check valve 21 and the filter 22 are attached in advance.

The gas introduction interface 44 of the external gas supply device is connected to the interface fitting portion 27 of the pressure supplier 9, the valve opening pin 49 is inserted into the ventilation hole 20 to push and open the check valve 21, and the pressure supply device 4 and the containing space 17 are made to communicate with each other.

At the same time, the gas introduction interface 44 is connected to the interface fitting portion 27 of the pressure governor 10, the valve opening pin 49 is inserted into the ventilation hole 20 to push and open the check valve 21, and the containing space 17 is opened to the outside.

In this state, while gas (dry air, dry nitrogen, dry argon and the like) is introduced, the gas in the containing space 17 is discharged from the pressure governor 10 to replace the gas inside the containing space 17.

After replacement for a predetermined time, the valve opening pin 49 of the gas leading-out interface is pulled out to operate the check valve 21. As a result, the pressure in the containing space 17 of the pressure container 3 for containing a thin plate is raised till it reaches the set pressure. If the pressure in the containing space 17 reaches the set pressure, the valve opening pin 49 of the gas introduction interface 44 is pulled out, and the gas introduction interface 44 is removed.

Then, the opening and closing pressure regulating valve 42 of the pressure supply device 4 is opened, and the inside of the containing space 17 is maintained at the set pressure. In this state, while the inside of the pressure container 3 for containing a thin plate is kept clean, the pressure container 3 for containing a thin plate is transported to the destination.

If the pressure supply device 4 is not attached on the pressure container 3 for containing a thin plate, the gas is supplied into the pressure container 3 for containing a thin plate from the gas introduction interface 44 so that the inside of the pressure container 3 for containing a thin plate is set at the set pressure, and the gas introduction interface 44 is removed. As a result, the inside of the pressure container 3 for containing a thin plate becomes at the set pressure and the pressure is gradually lowered. However, in this case, since a gap between the base 6 and the cover 7 is sealed by the lip portion 32 of the seal 11 pressed by the set pressure, the pressure inside the pressure container 3 for containing a thin plate can be maintained at a pressure higher than the outside pressure at such a level of several hundred hours far exceeding a time (approximately several days) required for the transport.

### [Effect]

As mentioned above, since the pressure container 3 for containing the reticle 2 inside can be maintained in a state where the pressure inside the pressure container 3 for containing a thin plate is higher than the outside pressure all the time during the transport, the inside of the containing space 17 in which the reticle 2 is contained can be kept at high cleanliness for a long time, and the safety in transport of the reticle 2 can be improved.

Also, if the transport or storage is conducted in a state where the pressure supply device 4 is connected to the pressure container 3 for containing a thin plate, the inside of the containing space 17 can be supported at the set pressure for a longer time, so that the safety in transport and storage of the reticle 2 can be improved.

### [Reticle case]

Subsequently, the reticle case will be described.

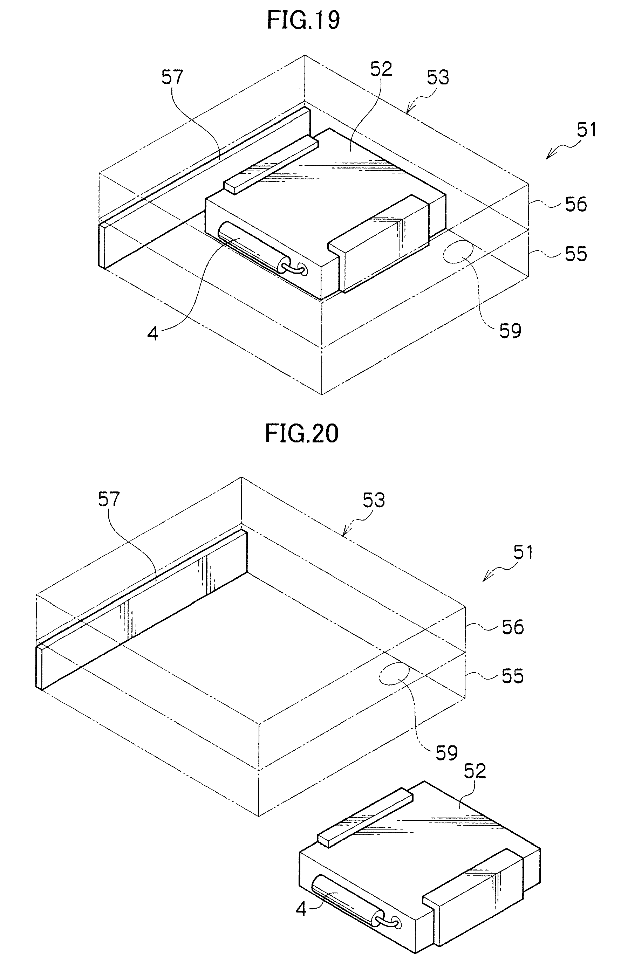

The reticle case is a case constituted by use of the thin plate storage transport system 1 as it is. A reticle case 51 is constituted by, as shown in Figs. 19 and 20, an inner container 52 and an outer container 53.

The inner container 52 uses the pressure container 3 for containing a thin plate of the thin plate storage transport system 1. Thus, the inner container 52 is constituted by a receiving body (base 6) for containing the reticle 2, a lid body (cover 7) attached by covering the receiving body, and a seal 11 for airtightly isolating the containing space 17 formed inside when the receiving body is closed and covered by the lid body from the outside environment. On the outside of the inner container 52, the pressure supply device 4 is provided. In the pressure container 3 for containing a thin plate of the thin plate storage transport system 1, the pressure supply device 4 is contained inside, but in this case, the pressure supply device 4 is provided outside the inner container 52. By means of the pressure supply device 4, the pressure is supplied into the containing space 17 of the inner container 52, and the pressure in the containing space 17 is kept at the set pressure higher than the pressure in the outer container 53. Reticle 2 may have nothing on the surface or may have a pellicle.

The outer container 53 is a container for containing the inner container 52 inside. The outer container 53 is constituted by an outer receiving body 55 and an outer lid body 56.

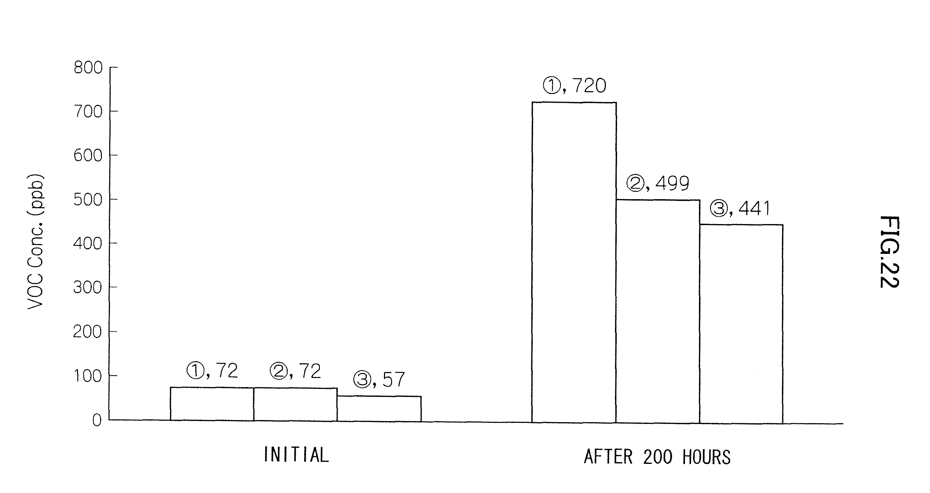

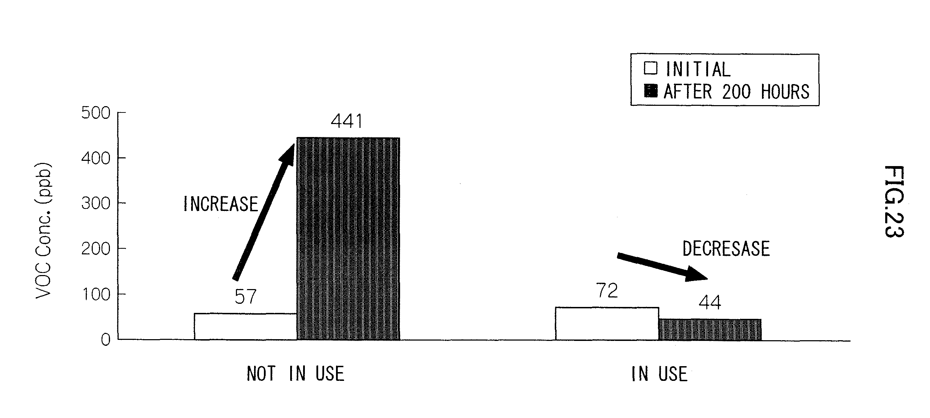

The outer receiving body 55 is formed in a shallow disc shape. At least an upper part of a wall plate around the outer receiving body 55 is formed by being enlarged to a size that the seal receiver 14 of the pressure container 3 for containing a thin plate can be formed, and a seal receiver (not shown) similar to the seal receiver 14 of the pressure container 3 for containing a thin plate is provided. On the inner side face of the wall plate in the outer receiving body 55, a chemical absorber 57 is provided. The chemical absorber 57 is an absorbing agent which absorbs and eliminates a volatile organic compound (a collective name (VOC) of organic compounds which have volatility and become gas in an atmosphere and include various substances such as toluene, xylene, and acetic ethyl) which might be generated from the inner container 52 or the outer container 53. An example of a change in VOC concentration caused by the chemical absorber 57 is shown in Figs. 22 and 23. Fig. 22 is an example in which the same reticle case is subjected to an experiment three times without using the chemical absorber. Referring to the change in the VOC concentration after 200 hours, a value becomes close to 10 times of the initial value. On the contrary, Fig. 23 shows an experiment example using the chemical absorber 57. As is known from the experiment results, when the chemical absorber 57 is not used, the VOC concentration becomes a value close to 10 times of the initial value after 200 hours, while when the chemical absorber 57 is used, the value is reduced to approximately 2/3 of the initial value. In this way, since the chemical absorber 57 is highly effective in reducing the VOC concentration, it is used for the reticle case.

The chemical absorber 57 is formed in a rectangular thin plate shape in order to raise adsorption efficiency by increasing an adsorption area. It is set to a dimension covering almost the whole surface of the inner side face of the wall plate, which is one side of the outer receiving body 55. The chemical absorber 57 may be provided partially other than provided substantially on the whole surface of the inner side face of the wall plate, which is one side of the outer receiving body 55. The chemical absorber 57 may be provided only in the inner container 52. Or, it may be provided both on the outer container 53 and inside the containing space 17 of the inner container 52 so that the volatile organic compounds are adsorbed from both sides of the space in the outer container 53 and the space in the inner container 52.

On a bottom face of the outer receiving body 55, an inner-container constraining portion (not shown) for supporting and constraining the inner container 52 is provided. The inner-container constraining portion is constituted by attaching an elastic member (synthetic resin or the like having elasticity and electricity charging properties) provided with a dent in conformity with the outer shape of the inner container 52 to the outer receiving body 55 and the like. It may be constrained by providing constraining means such as a hook. Known constraining means can be used. The constraining means is constituted by a material having conductivity or a nonconductive material.

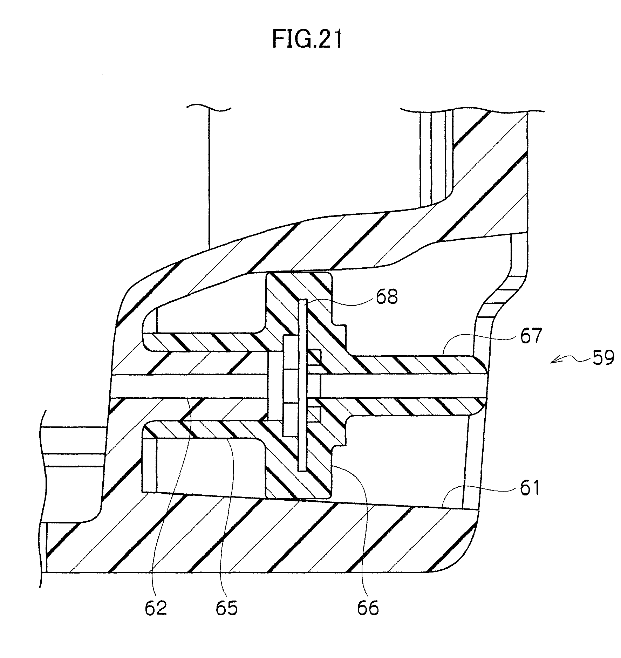

The outer lid body 56 has a shape similar to that of the outer receiving body 55. Specifically, it is formed in a reversed shallow disc shape and attached to the upper side of the outer receiving body 55. At a lower part of the wall plate around the outer lid body 56, a seal is brought into close contact on the inner side face while being fitted with the outer periphery of the seal receiver 14. A respiratory valve 59 is provided on the wall plate of the outer lid body 56. The respiratory valve 59 is, as shown in Fig. 21, attached by being fitted in a fitted pipe 62 of a valve containing recess portion 61. The respiratory valve 59 is specifically constituted by a fitting pipe portion 65, a filter containing portion 66, and an open pipe portion 67. The fitting pipe portion 65 is a portion to be fitted with the fitted pipe 62 of the valve containing recess portion 61. By fitting the fitting pipe portion 65 with the fitted pipe 62, the inside and the outside of the outer container 53 are made to communicate with each other through a membrane filter 68, which will be described later. The filter containing portion 66 is a portion which contains and supports the membrane filter 68. The filter containing portion 66 is formed in a thin disc shape and has the membrane filter 68 in a thin disc shape contained inside. The open pipe portion 67 is a portion forming a communication path communicating from the fitted pipe 62 of the valve containing recess portion 61 to the outside through the membrane filter 68. By means of the respiratory valve 59 with the above configuration, if the internal pressure becomes high, passage of the gas inside is allowed, while if the external pressure becomes high, passage of the outside gas is allowed to solve a difference between the internal pressure and the external pressure of the outer container 53. Particularly in order to prevent intrusion of a particle or the like into the inner container 52 when the internal pressure of the inner container 52 becomes lower than the pressure outside the inner container 52 (internal pressure of the outer container 53), abnormal rise of the internal pressure of the outer container 53 should be restrained. Therefore, the abnormal rise of the internal pressure of the outer container 53 is restrained by adjustment with the respiratory valve 59 so that the internal pressure of the outer container 53 becomes equal to the external pressure. The respiratory valve 59 might be provided in two pieces or more if required for this adjustment function.

The outer receiving body 55 and the outer lid body 56 constituting the outer container 53 are formed by an antistatic polymer material to prevent adsorption of particles and the like due to static electricity. Moreover, the inner container 52 and the outer container 53 prevent adsorption of the particles and the like due to static electricity by being electrically connected by the inner-container constraining portion.

The outer receiving body 55 and the outer lid body 56 are constrained to each other by constraining means (not shown). As the constraining means, the same member as the stopper 8 of the thin plate storage transport system 1 can be used. Alternatively, constraining means in another structure may be used.

### [Operation]

The reticle case constituted as above is used as follows.

A use mode of the inner container 52 is similar to that of the thin plate storage transport system 1. Processing such as containing of the reticle 2 inside and adjusting the inside of the containing space 17 to the set pressure is performed.

Then, the outer lid body 56 of the outer container 53 is removed from the outer receiving body 55 to open the inside of the outer container 53.

Then, the inner container 52 is attached and constrained to the inner-container constraining portion of the outer receiving body 55 of the outer container 53, the outer lid body 56 is attached, and the outer receiving body 55 and the outer lid body 56 are constrained to each other.

This operation is carried out in a clean atmosphere, and the inside of the outer container 53 is kept in a clean state.

Alternatively, the pressure supplier 9 and the pressure governor 10 of the thin plate storage transport system 1 are also provided at the outer container 53, and the inside of the outer container 53 is replaced by a clean gas from an outside pressure supply device (not shown).

The reticle case is transported to the destination in this state, the outer lid body 56 of the outer container 53 is removed from the outer receiving body 55, and the inner container 52 is taken out of the outer container 53.

Then, the inner container 52 is processed similarly as with the thin plate storage transport system 1.

### [Effect]

As mentioned above, in transport of the reticle 2, a clean state is ensured in the inner container 52, and a clean state of the atmosphere of the inner container 52 is also ensured by the outer container 53, and safety in transport of the reticle 2 can be improved.

### Industrial Applicability

In the above embodiment, as the pressure supply device 4, a device provided with a pressure cylinder is explained as an example, but if the pressure supply device 4 is not transported with the pressure container 3 for containing a thin plate, the pressure supply device 4 may be constituted as a large-sized device such as a device provided with a pressure pump.

Also, if the pressure supply device 4 is not transported with the pressure container 3 for containing a thin plate, the pressure supply device may be provided in a rack for pressure container for containing a thin plate. The rack for pressure container for containing a thin plate is a shelf member for containing and storing a plurality of the pressure containers 3 for containing a thin plate side by side. In this case, the pressure supply device is disposed so that the gas introduction interface and the gas leading-out interface are located at a position of the rack for pressure container for containing a thin plate in which each of the pressure containers 3 for containing a thin plate is contained and at a position opposing the interface fitting portion 27 of the ventilation hole 20. As a result, by containing the pressure containers for containing a thin plate in the rack for the pressure container for containing a thin plate, the pressure inside the pressure container for containing a thin plate can be automatically adjusted to the set pressure.

In the above embodiment, the only one pressure supply device 4 is provided in the pressure container 3 for containing a thin plate, but it is also possible to provide two or more pressure supply devices 4. The number of pressure supply devices 4 is set, considering the size of the container 3 for containing a thin plate and the capacity of the pressure supply device 4 and the like.

In the above embodiment, the thin plate storage transport system 1 which can contain the only one reticle 2 and the reticle case 51 are described as an example, but the present invention can be applied to a case of a container for containing a thin plate which contains a large number of semiconductor wafers. In this case, too, the same action and effect as those of the above embodiment can be exerted.

## Claims

1. A thin plate storage transport system, comprising:
a pressure container for containing a thin plate including a container main body for containing one or a plurality of thin plates, a lid body attached by covering said container main body, and a seal for airtightly isolating a containing space formed inside from an outside environment when the container main body is closed and covered by the lid body; and
a pressure supply device for setting a pressure in the containing space at a set pressure higher than an outside pressure by supplying a pressure into said containing space of the pressure container for containing a thin plate.

2. The thin plate storage transport system according to claim 1, wherein
said pressure supply device comprises a pressure cylinder and is incorporated in said pressure container for containing a thin plate.

3. The thin plate storage transport system according to claim 1, further comprising:
a rack for pressure container for storing said pressure container for containing a thin plate; and
a connection fitting that connects the pressure container for containing a thin plate and said pressure supply device provided on said rack for pressure container side by attaching said pressure container for containing a thin plate to the rack for pressure container.

4. The thin plate storage transport system according to claim 1, further comprising:
a ventilation hole provided at one or both of said container main body or the lid body for communicating the inside of said containing space and the outside; and
a check valve provided at the ventilation hole for allowing a flow of gas into said containing space from outside and for preventing a flow opposite thereto at the same time.

5. The thin plate storage transport system according to claim 4, wherein
a chemical filter is provided at said ventilation hole.

6. The thin plate storage transport system according to claim 4, wherein
said check valve is provided with a mechanism that can be opened by an operation from outside.

7. The thin plate storage transport system according to claim 6, wherein
said ventilation hole is provided in two pieces or more, and at least two of the plurality of ventilation holes are provided at a gas introduction interface and a gas leading-out interface provided at said pressure supply device capable of connection; and
said pressure supply device is connectably provided with an opening and closing mechanism for opening and closing control of the check valve of said ventilation hole.

8. The thin plate storage transport system according to claim 1, wherein
the seal has at least one lip and also has at least one protruding portion at a portion facing a seal receiver formed on said container main body or the lid body.

9. The thin plate storage transport system according to claim 1, wherein
the setting pressure by the pressure supply device is 1.1 atmospheric pressure or more and less than 2 atmospheric pressure.

10. The pressure container for containing a thin plate according to claim 1, wherein
a chemical absorber is provided inside said containing space.

11. A reticle case, comprising:
an inner container including a receiving body for containing a reticle, a lid body attached by covering the receiving body, and a seal for airtightly isolating a containing space formed inside from an outside environment when said receiving body is closed and covered by the lid body;
an outer container in which the inner container is contained; and
a pressure supply device for setting a pressure inside the containing space at a set pressure higher than a pressure in said outer container by supplying a pressure into said containing space of said inner container.

12. The reticle case according to claim 11, further comprising
a plurality of supporting bodies for sandwiching said reticle contained in said containing space on each of inner faces of said receiving body and said lid body of said inner container.

13. The reticle case according to claim 11, wherein
said outer container has an outer receiving body and an outer lid body and comprises a seal for airtightly isolating the inside of the outer container from an environment when the outer receiving body is closed by said outer lid body;
an inner-container constraining portion for supporting and constraining said inner container;
at least one respiratory valve provided with a membrane filter inside and communicating with the outside environment through the membrane filter; and
an outer connection portion for connecting said outer receiving body and said lid body when said outer receiving body is closed by said lid body.

14. The reticle case according to claim 11, wherein
said pressure supply device is attached into said outer container.

15. The reticle case according to claim 11, wherein
said inner container and the outer container is formed by an antistatic polymer material, and a path between the inner container and the outer container are electrically connected.

16. The reticle case according to claim 11, wherein
said pressure supply device comprises a pressure cylinder and is incorporated in said pressure container for containing a thin plate.

17. The reticle case according to claim 11, further comprising:
a rack for pressure container for storing said pressure container for containing a thin plate; and
a connection fitting for connecting the pressure container for a thin plate and said pressure supply device provided on said rack for pressure container side by attaching said pressure container for containing a thin plate to the rack for pressure container.

18. The reticle case according to claim 11, further comprising:
a ventilation hole provided at one or both of said container main body or the lid body for communicating the inside of said containing space and the outside; and
a check valve provided at the ventilation hole for allowing a flow of a gas into said containing space from outside and for preventing a flow opposite thereto at the same time.

19. The reticle case according to claim 18, wherein
a chemical filter is provided at said ventilation hole.

20. The reticle case according to claim 18, wherein
said check valve is provided with a mechanism that can be opened by an operation from outside.

21. The reticle case according to claim 20, wherein
said ventilation hole is provided in two pieces or more, and at least two of the plurality of ventilation holes are connectably provided at a gas introduction interface and a gas leading-out interface provided at said pressure supply device; and
said pressure supply device is provided with an opening and closing mechanism for opening and closing control of the check valve of said ventilation hole.

22. The reticle case according to claim 11, wherein
the seal has at least one lip and also has at least one protruding portion at a portion facing a seal receiver formed on said container main body or the lid body.

23. The reticle case according to claim 11, wherein
the setting pressure by the pressure supply device is 1.1 atmospheric pressure or more and less than 2 atmospheric pressure.

24. The reticle case according to claim 11, wherein
a chemical absorber is provided inside said containing space.
